(19) **Europäisches Patentamt / European Patent Office / Office européen des brevets**

(11) **EP 4 769 476 A1**

(12) **EUROPEAN PATENT APPLICATION**

(43) Date of publication:
**01.07.2026 Bulletin 2026/27**

(21) Application number: **25226712.5**

(22) Date of filing: **23.12.2025**

(51) International Patent Classification (IPC):
**H01J 37/302** (2006.01)      **H01J 37/317** (2006.01)

(52) Cooperative Patent Classification (CPC):
**H01J 37/3026; H01J 37/3177;** H01J 2237/31764

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **27.12.2024 EP 24223424**

(71) Applicant: **IMS Nanofabrication GmbH**
**2345 Brunn am Gebirge (AT)**

(72) Inventors:
• **Liertzer, Matthias**
  **2371 Hinterbrühl (AT)**
• **Hochleitner, Gottfried**
  **1140 Vienna (AT)**
• **Naetar, Wolf**
  **1080 Vienna (AT)**

(74) Representative: **Patentanwaltskanzlei Matschnig & Forsthuber OG**
**Biberstraße 22**
**Postfach 36**
**1010 Wien (AT)**

(54) **PARTICLE-BEAM WRITING METHOD USING A STRIPE EXPOSURE ORDER WITHIN A FINITE STRIPE WINDOW**

(57)    For irradiating a target with a charged-particle beam, a plurality of stripes are written using the beam at respective stripe locations ($y_0$-$y_{15}$). In order to reduce charging effects during irradiation, the time sequence of the stripes, expressed as a function $y(k)$ of a time index $k$, is different from a direct linear order. Based on a pre-determined integer number w ("stripe wing number") which is not larger than the number of stripes divided by at least 4, the time sequence for writing the stripe of location $y(k)$ at time index $k$ is rearranged so as to comply with the condition that the stripe at a location $y(k)$ is at most w stripe locations before the stripe location $y_k$ and at most w stripe locations behind the stripe location $y_k$, and/or between each pair of spatially directly neighboring stripes, at most 2w different stripes are written.

Fig. 11

EP 4 769 476 A1

**Description**

Field of the invention and description of prior art

The invention relates to a method for irradiating a target with a beam of electrically charged particles to write a desired pattern, for instance by means of a beam of energetic electrically charged particles generated in a charged-particle processing apparatus.

In a charged-particle multi-beam processing apparatus, a particle beam is generated in a charged-particle source, is directed to and illuminates a pattern definition device comprising an aperture array composed of a multitude of blanking apertures through which the particle beam penetrates, and is then imaged by a projection optics system onto a target, for writing a desired pattern on the target by exposing a multitude of pixels by means of the particle beam impinging on the target within a beam field of the target.

Methods and apparatuses of this kind are used in reticle manufacturing or maskless direct-write lithography. The applicant describes such methods and apparatuses, for instance, in US 9,520,268, US 6,768,125, US 8,222,621 and US 8,378,320. In particular, the applicant has realized a 50keV electron multi-beam writer to realize leading-edge complex photomasks for 193nm immersion lithography, of masks for EUV lithography and of templates (1x masks) for imprint lithography. The system is called eMET (electron Mask Exposure Tool) or MBMW (multi-beam mask writer) for exposing 6" mask blank substrates. The multi-beam column and writing method can also be used for multi-beam inspection applications.

As described earlier in US 8,378,320 and US 9,053,906 by the applicant, during a typical target exposure by a multi-beam charged-particle exposure apparatus, the mask is covered by multiple sets of possibly overlapping stripes ("multi-pass exposure") which can be exposed with in an arbitrary sequence. Additionally, the orientation of the stripes and exposure direction may vary as further explained by the applicant in US 9,799,487 and US 10,410,831.

The invention proposes a novel ordering of exposure of the exposure stripes, aiming to improve pattern placement accuracy over the whole mask.

Summary of the invention

The invention proposes an improved sequence of writing the plurality of stripes, in order to reduce charging effects during irradiation. The time sequence of the stripes (also referred to as "stripe ordering") is expressed as a function $y(k)$ of a time index $k$, and it is rearranged to be different from a direct linear order that would write the stripe by order of their respective stripe locations (denoted $y_i$ with $i = 0 ... N-1$, where $N$ is the total number of stripes). The stripe ordering is based on a pre-determined integer number $w$ ("stripe wing number") which is at most the number $N$ of stripes divided by at least 4; or if a more restrictive scheme is required, $w$ is not larger than the number obtained by decreasing the number $N$ of stripes by the numbers of directly adjacent or overlapping stripes that are written at the beginning and at the end of the writing procedure and then divided by at least 4. Using this stripe wing number $w$, the time sequence for writing the stripe of location $y(k)$ at time index $k$ is rearranged so as to comply with the condition that the stripe at a location $y(k)$ is at most $w$ stripe locations before the stripe location $y_k$ and at most $w$ stripe locations behind the stripe location $y_k$, and/or between each pair of spatially directly neighboring stripes, at most $2w$ different stripes are written.

More specifically, the invention is directed at a method for irradiating a target with a beam of energetic radiation formed by electrically charged particles to write a desired pattern, comprising the steps of

- generating said beam and forming it into a pattern image on the location of the target using a beam-generating column in accordance with the desired pattern, and

- generating a relative movement between said target and the beam-generating column producing a movement of said pattern image on the target along an exposure path over an exposure region where a beam exposure is to be performed, said exposure path being composed of sections which each extend along a general direction, said exposure region being composed of a plurality of pattern pixels (or more generally, pattern elements, which are formed in a pattern mask used as pattern definition device and may have polygonal shape as defined in the respective openings of the pattern mask) arranged in a regular arrangement and said exposure region having a total width as measured along a width direction across said general direction, wherein the movement along said exposure path defines a plurality of stripes extending along the general direction so as to combine into a cover of the exposure region in sequential exposures, said plurality of stripes comprising N stripes in said exposure region,

wherein each of the N stripes is located, with respect to the width direction, at a specific stripe location within said region, the stripes having a predetermined stripe width ys as measured along said width direction, wherein said stripe locations form a set of locations $y_i$ in which the stripes are identified by a width index $i$ and the locations $y_i$ are monotonously increasing as a function of the width index $i$,

wherein the plurality of stripes are written in a time sequence according to a time index k of the stripes, said time index starting from 0 for the stripe that is written first and incrementing by one for each consecutive stripe until N-1, said time sequence obeying the following conditions, which are based on a pre-determined integer number w which is smaller than the number of stripes N divided by at least 4 (or mathematically, w < N/4):

at each time index k the stripe corresponding to a stripe location y(k) is written, which stripe location y(k) is at most w stripe locations before the stripe location $y_k$, and at most w stripe locations behind the stripe location $y_k$, - or in other words, y(k) is in a stripe window ranging between $y_{(k-w)}$ and $y_{(k+w)}$ (inclusive), more exactly $y_{max(0, k-w)}$ and $y_{min(k+w, N-1)}$ (inclusive),

the stripe location y(k) is different from the k-th stripe location $y_k$ for at least a quarter, or preferably at least half, of the stripes,

between each pair of spatially directly neighboring stripes, at most 2w different stripes are written.

This solution according to the invention helps to mitigate or avoid unwanted effects that are associated with a build-up of charge caused by the irradiation during the writing process ("charge front"). It also helps to reduce problems associated with pattern placement and pattern accuracy over the whole mask ("global registration").

A more strict requirement of the stripe wing number w can be calculated by excluding the first and last stripes that are written consecutively according to their location: then, w may be determined to be not larger, or even be smaller, than a number calculated by decreasing the number of stripes N by the numbers $(k_1, k_N)$ of directly adjacent or overlapping stripes that are written at the beginning and at the end of the exposure path, then dividing by 4. Put mathematically, $w \leq (N-(k_1+k_N))/4$, or even $w < (N-(k_1+k_N))/4$. It is to be noted that the numbers $k_1$ and $k_N$ are always at least one, $k_1 \geq 1$, $k_N \geq 1$ (there is always a first stripe, and there is always a last stripe).

In many advantageous implementations of the invention, the stripe data that relate to a pattern to be written by writing the stripes are cached in a cache memory; in such a case it is advantageous to have the stripe wing number w being smaller than half the maximum number of stripes whose stripe data said cache memory is capable to keep simultaneously. This can ensure that the cache memory is used in an efficient manner.

In many embodiments of the invention the exposure path may comprises several passes, each pass being composed of sections which each extend along a general direction associated with the respective pass, wherein each pass includes a plurality of stripes extending along the general direction of the respective pass and the stripes of each pass combine into a cover of the exposure region in sequential exposures. In the case of multiple passes it is often advantageous to associate each pass with one of a number of partial grids of pattern pixels which are exposable during the respective pass, the partial grids being mutually different and, when taken together, combining to the complete plurality of pattern pixels which are comprised in the exposure region.

Many embodiments employ a multi-beam processing apparatus. In such implementations, the pattern image may include a plurality of aperture images covering a plurality of pixels on the target. Alternatively or in combination, generating the beam and forming it into a pattern image may includes:

- providing a pattern definition device having a plurality of apertures transparent to said radiation,
- illuminating said pattern definition device by means of an illuminating wide beam, which traverses the pattern definition device through said apertures thus forming a patterned beam consisting of a corresponding plurality of beamlets,
- forming said patterned beam into a pattern image on the location of the target, said pattern image comprising the images of at least part of the plurality of apertures.

The stripe ordering may be subject to the condition that between each pair of spatially directly neighboring or overlapping stripes, at least one different stripe is written, preferably at least two different stripes are written, possibly with the exception of directly adjacent or overlapping stripes that are written at the beginning and at the end of the exposure path.

As another condition of the stripe ordering for cases of multiple passes it may be suitable if between each pair of neighboring stripes of the same pass at least one different stripe is written; preferably in the case of more than two passes, severable stripes, namely from each of the other passes at least one stripe, are written.

Furthermore it may be advantageous if between each pair of spatially directly neighboring or overlapping stripes, the at most 2w different stripes are written within a maximum distance to said pair of spatially directly neighboring stripes, said maximum distance being at most 2w times the stripe width ys.

As a special case, which may be realized in many embodiments, it may be suitable to have the arrangement of stripes along the y-direction according to a linearly incrementing sequence. In such embodiments, the stripe locations of directly subsequent stripes differ by a uniform offset Dy (the stripe width ys is then an integer multiple of Dy) and the stripe locations $y_i$ form a linear sequence according to $y_i = y_0 + i.Dy$. Moreover, it may be provided in the case of multiple passes that the uniform offset Dy is the stripe width ys divided by the number of passes. However, other arrangements of stripe locations may be suitable as well, for instance a set of locations having groups of n stripes at the same location, such as

$$y_i = y_0 + \lfloor i/n \rfloor \cdot y_D \quad \text{or} \quad y_i = y_0 + \lfloor i/n_{passes} \rfloor \cdot ys,$$ where $\lfloor \cdot \rfloor$ denotes the floor function (rounding off) and $y_D$ is an width offset parameter; or the offset between subsequent stripes may vary cyclically between different passes, provided the offset between stripes of the same pass is uniform.

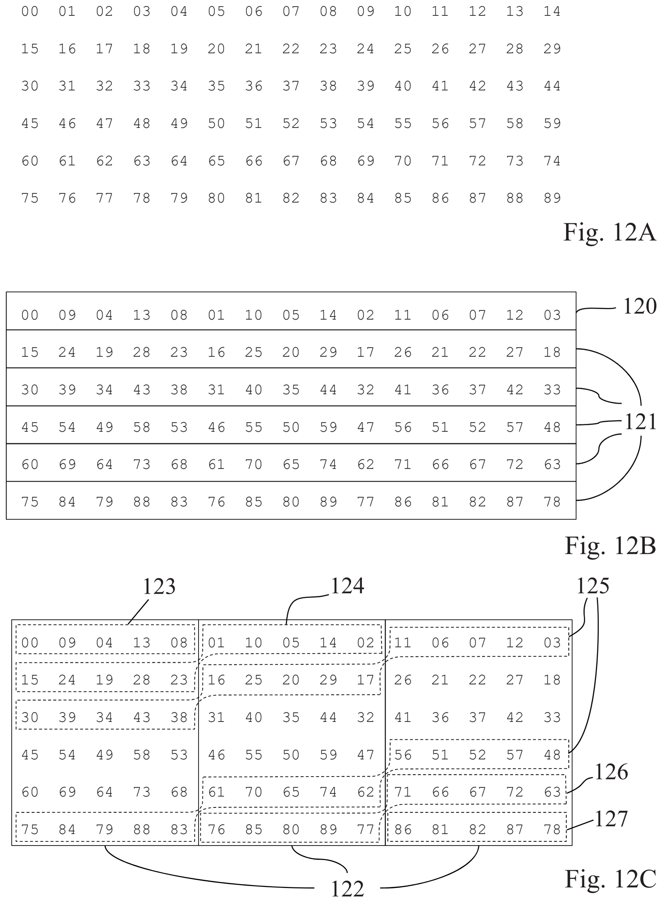

The invention also proposes several specific approaches of rearranged stripe orderings. These approaches can be combined one with another (see for example the embodiment of Figs.12A-D, which combines the two approaches as described in the next two sentences) and/or iterated with equal or preferably different parameters. One approach of rearranging the time sequence corresponds to a permutation of stripes within conceptual blocks of stripes, each of said blocks comprising the same number ($n_{block}$) of stripes except for rounding corrections, said number ($n_{block}$) of stripes within the blocks being chosen not exceeding 2w+1. Another approach of rearranging the time sequence corresponds to a permutation of block portions of stripes according to a conceptual partitioning of the sequence of stripes into consecutive block portions, conceptually numbered by a portion index m running from 0 up to M-1, and rearranging the order of block portions by grouping together up to n block portions (n being a predetermined integer) into n-1+M/n mutually disjoint groups referred to as cohorts, said cohorts being conceptually numbered by a cohort index j starting from 0, where the j-th cohort comprises a span of every (n-1)-th block portions, comprising the portion indices m= n·j, n·j-(n-1), ..., n·j-(n-1)$^2$ falling within the range of 0≤m<M; where the maximum number of stripes within each of said cohorts being chosen not exceeding 2w+1. Yet another approach of rearranging the time sequence corresponds to conceptual partitioning of stripes into at least two mutually disjoint sequence groups, each sequence group comprising a set of stripes which corresponds to every $n_p$-th stripe in the set of stripes as numbered by the width index i, where $n_p$ is the number of sequence groups, wherein based on $n_p$-1 pre-defined offsets $\omega_p$, where $\omega_0$=0 and $\omega_p + 1 < \omega_{p+1}$ for p=0... $n_p$-2, each non-first sequence group starts with its respective first stripe only after the first $\omega_{p+1} - \omega_p$ stripes of the respectively preceding sequence groups have been written, writing the stripes by cycling through the sequence groups which have been started and are not yet completed; the offsets being chosen such that 2w > ($\omega_{np}$ -$\omega_0$ + $n_p$)·($n_p$ - 1). The latter approach is particularly advantageous in connection with multiple passes, in that then each sequence groups corresponds to a respective pass. Also, the stripes of each sequence groups (or pass) may be mutually non-overlapping or only marginally overlapping.

<u>Brief description of the drawings</u>

In the following, the present invention is described in more detail with reference to the drawings, which schematically show:

Fig. 1          a typical MBMW system in a longitudinal sectional view;

Fig. 2          a pattern definition system state of the art in a longitudinal section;

Fig. 3          illustrates the basic writing strategy on the target using stripes;

Fig. 4          shows an example of an arrangement of stripes to be exposed according to the "double-pass" exposure method;

Figs. 5A, 5B    illustrate an example of an exposure sequence of stripes by order of their position, where Fig. 5A indicates the positions of the stripes and their respective times of exposure, and Fig. 5B indicates the stripe exposure sequence as function of the time index k;

Figs. 6A, 6B    illustrate an example of a stripe exposure sequence according to a "regional stripe order" approach, where Fig. 6A indicates the positions of the stripes and their respective times of exposure, and Fig. 6B indicates the stripe exposure sequence as function of the time index k;

Figs. 7A, 7B    illustrate an example of a stripe exposure sequence according to a "clustered regional stripe order" approach, where Fig. 7A indicates the positions and writing directions of the stripes and their respective times of exposure, and Fig. 7B indicates the stripe exposure sequence as function of the time index k;

Fig. 8          illustrates the effect of a charge front during exposure of adjacent stripes;

Fig. 9          is a flowchart of implementing a stripe exposure sequence of a first embodiment, referred to as cyclical shuffled stripe ordering;

Figs. 10A, 10B    illustrate an example of a stripe exposure sequence based on the cyclical shuffled stripe ordering, where Fig. 10A indicates the positions and writing directions of the stripes and their respective times of exposure, and Fig. 7B indicates the stripe exposure sequence as function of the time index k;

Fig. 11    illustrates another example of a stripe exposure sequence based on the cyclical shuffled stripe ordering, indicating the stripe exposure sequence as function of the time index k;

Fig. 12A to    12D illustrate the reordering of stripe exposure sequence according to a second embodiment, referred to as group-shuffled stripe ordering, where Fig. 12A illustrates a linear order of stripes as a starting point, Fig. 12B shows the reordering of the stripes according to blocks, Fig. 12C shows distributing the stripes into groups, Fig. 12D shows the stripe exposure sequence thus obtained;

Fig. 13    is a flowchart of the stripe exposure sequence of the embodiment of group-shuffled stripe ordering; and

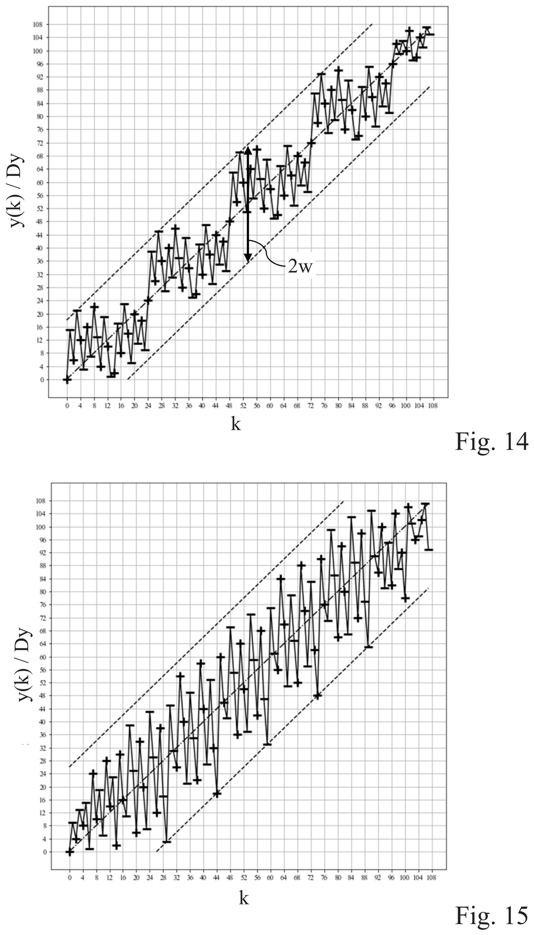

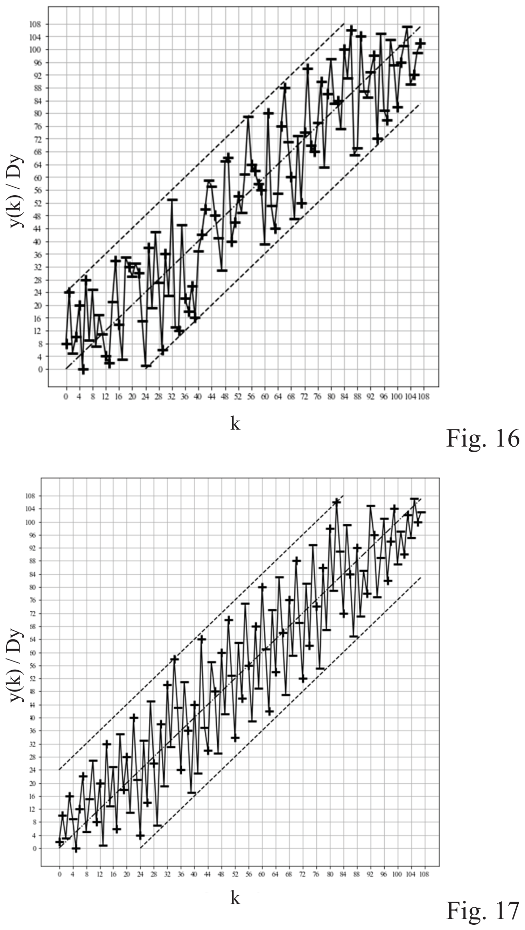

Fig. 14-17    illustrate further examples of stripe exposure sequences, indicating the stripe exposure sequence as function of the time index k, where: Fig. 14 illustrates an example of a stripe exposure sequence based on group-shuffled stripe ordering using a permutation with Fibonacci-hashing, Fig. 15 illustrates an example of a stripe exposure sequence based on group-shuffled stripe ordering with a combination of group-cycling and permutation within the blocks; Fig. 16 illustrates an example of a stripe exposure sequence based on general window-shuffled stripe ordering, employing a random permutation; and Fig. 17 illustrates an example of a stripe exposure sequence based on general window-shuffled stripe ordering, using a permutation with Fibonacci-hashing.

Detailed description of the invention

The detailed discussion given herein is intended to illustrate the invention and exemplary embodiments thereof, as well as further advantageous developments. It will be evident to the skilled person to freely combine several or all of the embodiments and aspects discussed here as deemed suitable for a specific application of the invention. Throughout this disclosure, terms like "advantageous", "favorable", "exemplary" or "preferred" indicate elements or dimensions which are particularly suitable (but not essential) to the invention or an embodiment thereof, and may be modified wherever deemed suitable by the skilled person, except where expressly stated otherwise. It will be appreciated that the invention is not restricted to the exemplary embodiments discussed in the following, which are given for illustrative purpose and merely present suitable implementations of the invention.

**Lithographic Apparatus**

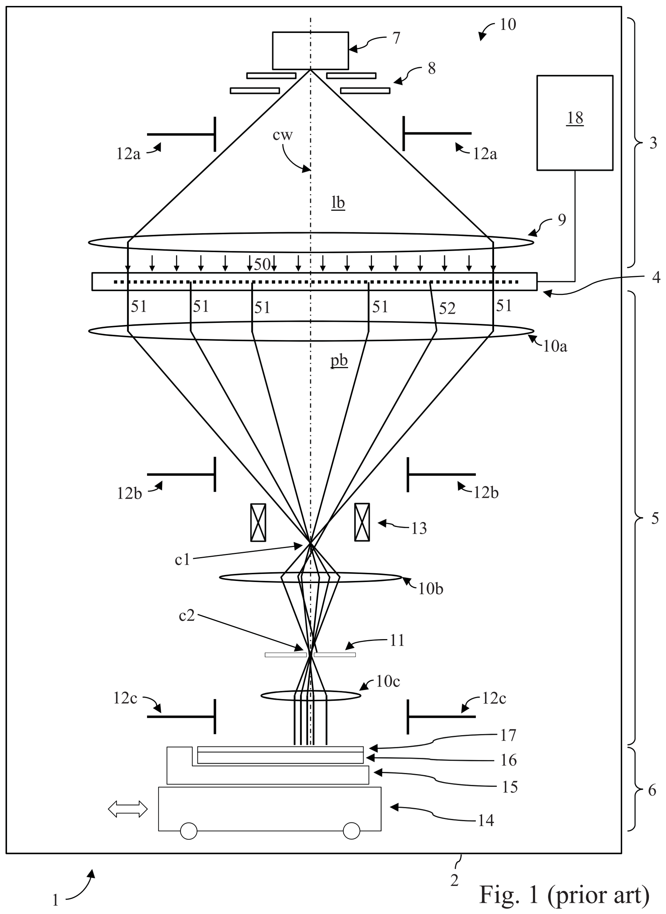

The preferred embodiment of the invention utilizes a charge-particle exposure apparatus as illustrated schematically in Fig. 1 (not to scale), which includes a beam-generating column 10 comprising an illumination system 3, a pattern definition system 4 (preferably forming the charged-particle lb beam into a plurality of sub-beams pb propagating in parallel), and a projecting system 5, and further includes a target station 6 containing a substrate to be exposed 16. The whole apparatus 1 is contained in a vacuum housing 2 held at high vacuum to ensure an unimpeded propagation of the beam lb, pb along the optical axis cx of the apparatus. The charged-particle optical systems 3, 5 are realized using electrostatic and/or magnetic lenses.
The illumination system 3 comprises, for instance, an electron gun 7, an extraction system 8 as well as a condenser lens system 9. It should, however, be noted that in place of electrons, in general, other electrically charged particles can be used as well. Apart from electrons these can be, for instance, hydrogen ions or heavier ions, charged atom clusters, or charged molecules.
The extraction system 8 accelerates the particles to a defined energy of typically several keV, e.g. 5 keV. By means of a condenser lens system 9, the particles emitted from the source 7 are formed into a broad, substantially telecentric particle beam 50 serving as lithography beam lb. The lithography beam lb then irradiates a PD system 4 which comprises a number of plates with a plurality of openings (also referred to as apertures). The PD system 4 is held at a specific position in the path of the lithography beam lb, which thus irradiates the plurality of apertures and/or openings and is split into a number of beamlets.
Some of the apertures/openings are "switched on" or "open" so as to be transparent to the incident beam in the sense that they allow the portion of the beam that is transmitted through it, i.e. the beamlets 51, to reach the target; the other apertures/openings are "switched off" or "closed", i.e. the corresponding beamlets 52 cannot reach the target, and thus effectively these apertures/openings are non-transparent (opaque) to the beam. Thus, the lithography beam lb is structured into a patterned beam pb, emerging from the PD system 4. The pattern of switched on apertures - the only portions of the PD system 4 which are transparent to the lithography beam lb - is chosen according to the pattern to be exposed on the substrate 16 covered with charged-particle sensitive resist 17. It has to be noted that the "switching on/ off" of the apertures/openings is usually realized by a suitable type of deflection means provided in one of the plates of the PD system 4. "Switched off" beamlets 52 are deflected off their path (by sufficient albeit very small angles) so they cannot reach the target but are merely absorbed somewhere in the lithography apparatus, e.g. at an absorbing plate 11.

The pattern as represented by the patterned beam pb is then projected by means of an electro-magneto-optical projection system 5 onto the substrate 16 where the beam forms an image of the "switched-on" apertures and/or openings. The projection system 5 implements a demagnification of, for instance, 200:1 with two crossovers c1 and c2. The substrate 16 is, e.g., a 6" mask blank or a silicon wafer covered with a particle sensitive resist layer 17. The substrate is held by a chuck 15 and positioned by a substrate stage 14 of the target station 6. The substrate stage 14 is, for example, an air-bearing X-Y vacuum stage able to perform high stage velocity in X as well as in Y direction.

The information regarding the pattern to be exposed is supplied to the PD system 4 by the data path realized by means of an electronic pattern information processing system 18. A suitable implementation of a data path is described in US 10,325,757 of the applicant, for instance.

In the embodiment shown in Fig. 1, the projection system 5 is composed of a number of consecutive electro-magneto-optical projector stages 10a, 10b, 10c, which preferably include electrostatic and/or magnetic lenses, and possibly other deflection means. These lenses and means are shown in symbolic form only, since their application is well known in the prior art. The projection system 5 employs a demagnifying imaging through crossovers c1, c2. The demagnification factor for both stages is chosen such that an overall demagnification of several hundred results, e.g. 200:1 reduction.

In the whole projection system 5, provisions are made to extensively compensate the lenses and or deflection means with respect to chromatic and geometric aberrations. As a means to shift the image laterally as a whole, i.e. along a direction perpendicular to the optical axis cw, deflection means 12a, 12b and 12c are provided in the condenser 3 and projection system 5. The deflection means may be realized as, for instance, a multipole electrode system which is either positioned near the source extraction system 12a or one of the crossovers, as shown in Fig. 1 with the deflection means 12b, or after the final lens 10c of the respective projector, as in the case with the stage deflection means 12c in Fig. 1. In this apparatus, a multipole electrode arrangement is used as deflection means both for shifting the image in relation to the stage motion and for correction of the imaging system in conjunction with the charge-particle optics alignment system. These deflection means 10a, 10b, 10c are not to be confused with the deflection array means of the PD system 4 in conjunction with the stopping plate 11, as the latter are used to switch selected beamlets of the patterned beam pd "on" or "off", whereas the former only deal with the particle beam as a whole. There is also the possibility to rotate the ensemble of programmable beams using a solenoid 13 providing an axial magnetic field.

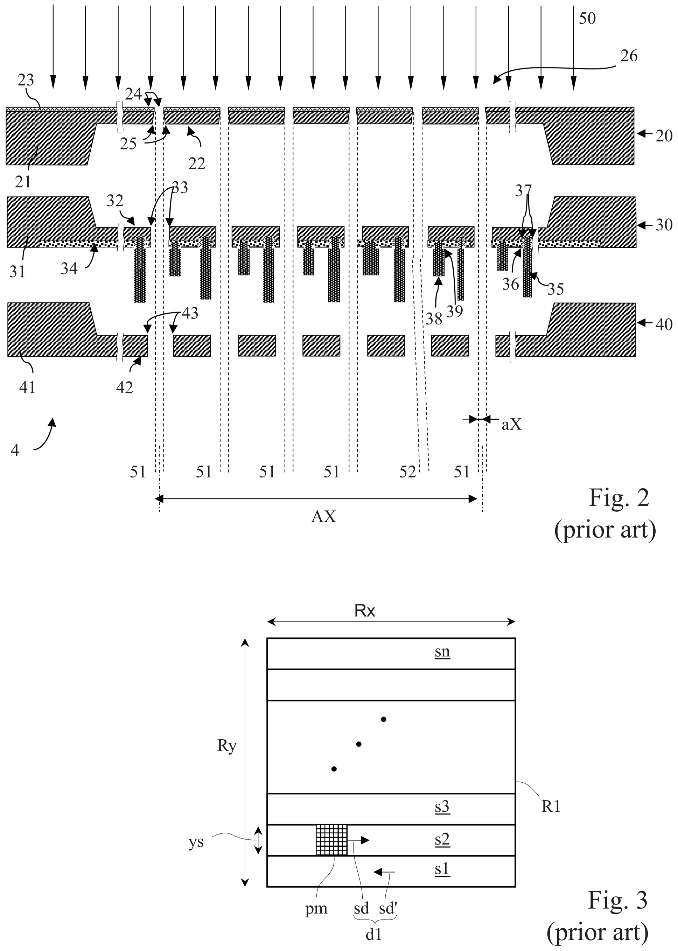

The sectional detail of Fig. 2 illustrates one suitable embodiment of a PD system 4, which comprises three plates stacked in a consecutive configuration: An "Aperture Array Plate" (AAP) 20, a "Deflection Array Plate" (DAP) 30 and a "Field-boundary Array Plate" (FAP) 40. It is worthwhile to note that the term 'plate' refers to an overall shape of the respective device, but does not necessarily indicate that a plate is realized as a single plate component even though the latter is usually the preferred way of implementation; still, in certain embodiments, a 'plate', such as the aperture array plate, may be composed of a number of sub-plates. The plates are preferably arranged parallel to each other, at mutual distances along the Z direction (vertical axis in Fig. 2).

The flat upper surface of AAP 20 forms a defined potential interface to the charged-particle condenser optics/illumination system 3. The AAP may, e.g. be made from a square or rectangular piece of a silicon wafer (approx. 1mm thickness) 21 with a thinned center part 22. The plate may be covered by an electrically conductive protective layer 23 which will be particularly advantageous when using hydrogen or helium ions (line in US 6,858,118). When using electrons or heavy ions (e.g. argon or xenon), the layer 23 may also be of silicon provided by the surface section of 21 and 22, respectively, so that there is no interface between layer 23 and the bulk parts 21, 22.

The AAP 20 is provided with a plurality of apertures 24 formed by openings traversing the thinned part 22. The apertures 24 are arranged in a predetermined arrangement within an aperture area provided in the thinned part 22, thus forming an aperture array 26. The arrangement of the apertures in the aperture array 26 may be, for instance, a staggered arrangement or a regular rectangular or square array. In the embodiment shown, the apertures 24 are realized having a straight profile fabricated into the layer 23 and a "retrograde" profile in the bulk layer of the AAP 20 such that the downward outlets 25 of the openings are wider than in the main part of the apertures 24. Both the straight and retrograde profiles can be fabricated with state-of-the-art structuring techniques such as reactive ion etching. The retrograde profile strongly reduces mirror charging effects of the beam passing through the opening.

The DAP 30 is a plate provided with a plurality of openings 33, whose positions correspond to those of the apertures 24 in the AAP 20, and which are provided with electrodes 35, 38 configured for deflecting the individual beamlets passing through the openings 33 selectively from their respective paths. The DAP 30 can, for instance, be fabricated by post-processing a CMOS wafer with an ASIC circuitry. The DAP 30 is, for instance, made from a piece of a CMOS wafer having a square or rectangular shape and comprises a thicker part 31 forming a frame holding a center part 32 which has been thinned (but may be suitably thicker as compared to the thickness of 22). The aperture openings 33 in the center part 32 are wider compared to 24 (by approx. $2\mu m$ at each side for instance). CMOS electronics 34 is provided to control the electrodes 35, 38, which are provided by means of MEMS techniques. Adjacent to each opening 33, a "ground" electrode 35 and a deflection electrode 38 are provided. The ground electrodes 35 are electrically interconnected, connected to a common ground potential, and comprise a retrograde part 36 to prevent charging and an isolation section 37 in order to prevent unwanted shortcuts to the CMOS circuitry. The ground electrodes 35 may also be connected to those parts of the CMOS circuitry 34 which are at the same potential as the silicon bulk portions 31 and 32.

The deflection electrodes 38 are configured to be selectively applied an electrostatic potential; when such electrostatic potential is applied to an electrode 38, this will generate an electric field causing a deflection upon the corresponding beamlet, deflecting it off its nominal path.

The electrodes 38 as well may have a retrograde section 39 in order to avoid charging. Each of the electrodes 38 is connected at its lower part to a respective contact site within the CMOS circuitry 34.

The height of the ground electrodes 35 is higher than the height of the deflection electrodes 38 in order to suppress cross-talk effects between the beamlets.

The arrangement of a PD system 4 with a DAP 30 shown in Fig. 2 is only one of several possibilities. In a variant (not shown) the ground and deflection electrodes 35, 38 of the DAP may be oriented upstream (facing upward), rather than downstream. Further DAP configurations, e.g. with embedded ground and deflection electrodes, can be devised by the skilled person (see other patents in the name of the applicant, such as US 8,198,601 B2).

The third plate 40 serving as FAP has a flat surface facing to the first lens part of the downstream demagnifying charged-particle projection optics 5 and thus provides a defined potential interface to the first lens 10a of the projection optics. The thicker part 41 of FAP 40 is a square or rectangular frame made from a part of a silicon wafer, with a thinned center section 42. The FAP 40 is provided with a plurality of openings 43 which correspond to the openings 24, 33 of the AAP 20 and DAP 30 but are wider as compared to the latter .

The PD system 4, and in particular the first plate of it, the AAP 20, is illuminated by a broad charged particle beam 50 (herein, "broad" beam means that the beam is sufficiently wide to cover the entire area of the aperture array formed in the AAP), which is thus divided into many thousands of micrometer-sized beamlets 51 when transmitted through the apertures 24. The beamlets 51 will traverse the DAP and FAP unhindered.

As already mentioned, whenever a deflection electrode 38 is powered through the CMOS electronics, an electric field will be generated between the deflection electrode and the corresponding ground electrode, leading to a small but sufficient deflection of the respective beamlet 52 passing through (Fig. 2). The deflected beamlet can traverse the DAP and FAP unhindered as the openings 33 and 43, respectively, are made sufficiently wide. However, the deflected beamlet 52 is filtered out at the stopping plate 11 of the sub-column (Fig. 1). Thus, only those beamlets which are unaffected by the DAP will reach the substrate.

The ensemble of (unaffected) beamlets 51 as formed by AAP is projected to the substrate with a predefined reduction factor R of the projection charged-particle optics. Thus, at the substrate a "beam array field" (BAF) is projected. The nominal width of a beamlet at the substrate (i.e. aperture image) is given by $bX = aX/R$ and $bY = aY/R$, respectively, where $aX$ and $aY$ denote the sizes of the beamlet 51 as measured along the X and Y directions, respectively, at the level of the DAP 30.

It is worthwhile to note that the individual beamlets 51, 52 depicted in Fig. 2 represent a much larger number of beamlets, typically many thousands, arranged in a two-dimensional X-Y array. The applicant has, for instance, realized multi-beam charged-particle optics with a reduction factor of R = 200 for ion as well as electron multi-beam columns with many thousands (e.g., 262,144) programmable beamlets. The applicant has realized such columns with a BAF of approx. $82\mu m \times 82\mu m$ at the substrate. These examples are stated for illustrative purpose, but are not to be construed as limiting examples.

**Stripe scanning and multi-pass exposure**

Referring to Fig. 3, a pattern image pm as defined by the PD system 4 is produced on the target 16. The target surface covered with the charged-particle sensitive resist layer 17 will comprise one or more areas R1 to be exposed. Generally, the pattern image pm exposed on the target has a finite size ys which is usually well smaller than the width of the exposure area (or exposure region) R1 which is to be patterned. Therefore, a scanning stripe exposure strategy is utilized, where the target is moved under the incident beam, so as to change the position of the beam on the target perpetually: the beam is effectively scanned over the target surface. It is emphasized that for the purpose of the invention only the relative motion of the pattern image pm on the target is relevant. By virtue of the relative movement the pattern image pm is moved over the exposure area R1 so as to form stripes s1, s2, s3, ... sn (exposure stripes) of width ys. The complete set of stripes covers the total area of the substrate surface. The scanning direction sd may be uniform or may alternate from one stripe to the next; in the latter case we have a "positive" scanning direction sd and a "negative" direction sd', which is directly inverse to the "positive" scanning direction sd, and both directions are summarized by specifying a general direction d1 (which represents an orientation of movement irrespective of whether it is "forward" or "backward").

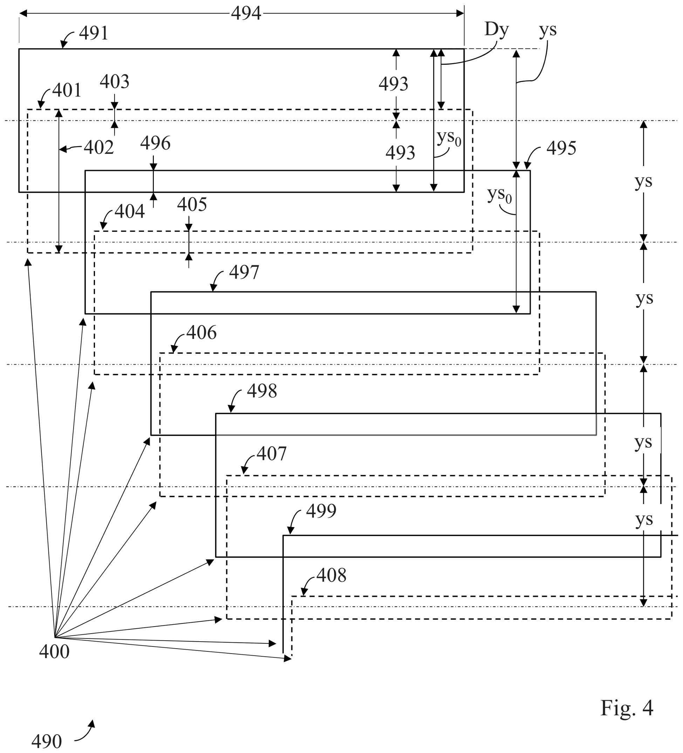

Further details regarding the preferred method for pattern generation and write strategy can be found in the above-mentioned references, in particular US 9,520,268, US 8,378,320 and US 9,053,906. In particular, the applicant proposed the use of overlapping exposure stripes 400 ("Multi-Pass") to average out errors due to imaging or alignment deviations and mitigate beam inhomogeneity. The concept is explained with reference to Fig. 4, which shows an exemplary layout 490 of a number stripes 400 in a "double-pass" multi-beam exposure. It is to be noted that Fig. 4, merely for purposes of visibility and better clarity, shows the stripes 400 in a staggered arrangement, i.e. mutually shifted along the X-direction; it will be understood that in a realistic multi-beam exposure the stripes align along the writing direction and are typically covering the same length along their common direction (in this case, the x-direction).

The exposure of the substrate field starts with exposing stripe 491 with a full width $ys_0$ (corresponding to the width of the beam-field array on the substrate, e.g. $82\mu m$). The symmetry line of stripe 491 is indicated as a dash-dotted line, at a distance 493 from the boundaries of stripe 491. The stripe has a length 494; e.g., for a mask exposure field this length 494 is 132mm. The next stripe 495, again with a full width $ys_0$, is exposed with an overlap of width 96 as described in patent US 8,378,320 of the applicant. In a typical example, this overlap width 496 is $2\mu m$, and the distance ys between the symmetry lines of stripe 491 and stripe 495 is $80\mu m$. Thus, the distance ys is an "effective stripe width" or simply "stripe width". The procedure continues with stripes 497, 498, 499 and so on, covering the area to be exposed in a first pass of stripes.

A second set of stripes 401, 404, 406, 407, 408 etc. is exposed preferably with 50% overlap (i.e. with an offset Dy which in this case is half of the effective stripe width ys) as shown in Fig. 15. These stripes form a second pass covering the area to be exposed on the target (except possibly for, albeit small, margins at the edge of the area). The full width 402 of these stripes is the same as the full width $ys_0$ of the stripes of the first pass. The upper boundary of stripe 401 is shifted by a distance 403 from the symmetry line of stripe 491, which is half of the overlap width 496.

The stripes 401 and 404 are exposed with a small overlap region 405, where the distance 405 is preferably the same as distance 496. The small overlap at the margin regions of widths 405, 496 is very small in realistic implementations (and exaggerated in Fig. 4 for better visibility), and considerably lower than the overlap between one stripe and the next one, as defined by the offset Dy. This small overlap is usually well below 5 %, preferably at most 2.5 %, preferably less than 1 %, of the stripe width ys. Stripes which are overlapping only with such a small overlap at their edges are herein called "marginally overlapping".

The stripes in a "multi-pass" exposure can be either written with a fraction exposure dose (e.g. 1/2 for a "double-pass" exposure), or, alternatively, only a fraction of the pixels is exposed in each pass. The latter approach is elaborated on in US 9,053,906 by the applicant.

## Stripe sequence

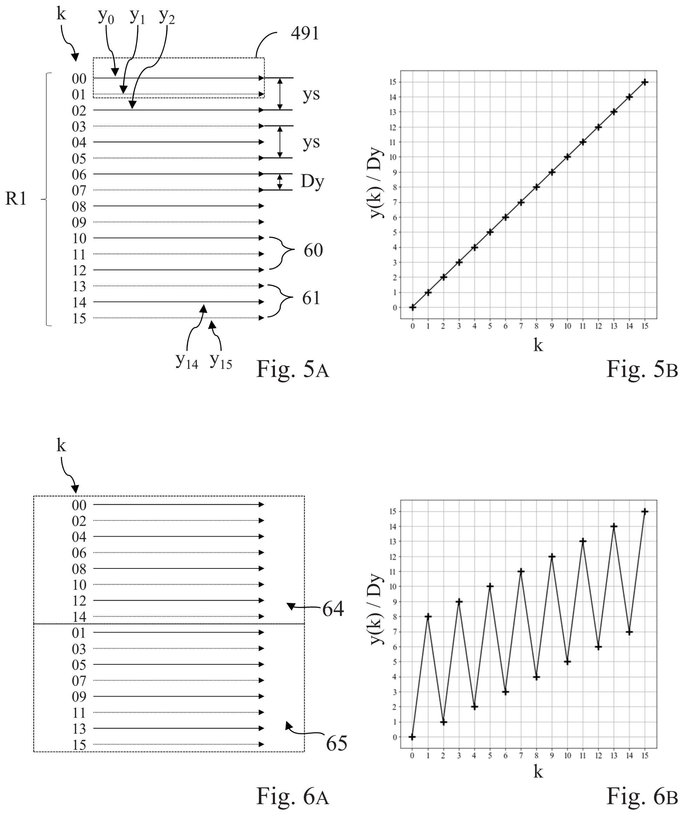

The order in which the stripes are exposed ("exposure sequence" or "stripe ordering") will be chosen suitably so as to achieve a precise yet fast exposure process. The exposure sequence is typically chosen with regard to effects of the charged particle beam on the substrate, e.g. substrate heating and resist charging. For reference, the simplest stripe exposure strategy for an exposure area R1 is an exposure sequence by order of position $y_0, y_1, y_2, ... y_{14}, y_{15}$ along the "top-down" direction y across the stripe-writing general direction d1. An example of this, in which 16 exemplary stripes (note that in real exposure, the number of stripes will typically be much higher) are exposed in order of their position $y_0, y_1, ... y_{15}$ in "top-down" direction, is illustrated in Figs. 5A and 5B. According to the "double-pass" exposure method (the same embodiment as in Fig. 4), the stripes are conceptually distributed into two groups ("passes") 60, 61, whose stripes are respectively shown as solid and dotted lines in Fig. 5A, with an arrow indicating the respective stripe-writing direction. In this example, all stripes are exposed from left to right. The stripes of each pass are mutually offset by the effective stripe width ys, which may be slightly smaller than the physical beam width 491, whereas neighboring stripes of different passes are offset by a distance Dy = ys/2 relative to one another. The stripe exposure sequence is indicated by means of a sequence of stripe position numbers y(k) (also referred to as stripe locations) as a function of the time index k = 1-15, and in the illustrative example of Figs. 5A and 5B, the stripe position matches the top-down order, i.e., $y(k) = y_k = k \cdot Dy$.

A more sophisticated exposure sequence was introduced by the applicant in US 9,053,906. In this variant ("regional stripe order"), the exposure area R1 on the target is conceptually split into different sub-regions, and the stripes of each sub-region are exposed in top-down order, while alternating between the sub-regions. This approach offers to homogenize substrate heating.

An example of this exposure sequence is illustrated in Figs. 6A and 6B, where two sub-regions 64 and 65 contain eight stripes each, and the stripes of each sub-region 64, 65 are exposed in top-down order from left to right, while alternating between the sub-regions 64, 65. This stripe ordering can be expressed by defining (using the modulo function, denoted by *mod*) for even k (i.e., k *mod* 2=0) the stripe location is y(k) = (k/2)·Dy, whereas for odd k (i.e., k *mod* 2 =1) it is y(k) = [8+(k-1)/2]·Dy. For a more general number of stripes and sub-regions,

$$y(k) = Dy \cdot [\ (N-1) \cdot (k\ mod\ n_r) + k\ ] / n_r$$

where N is the total number of stripes, and $n_r$ is the number of sub-regions.

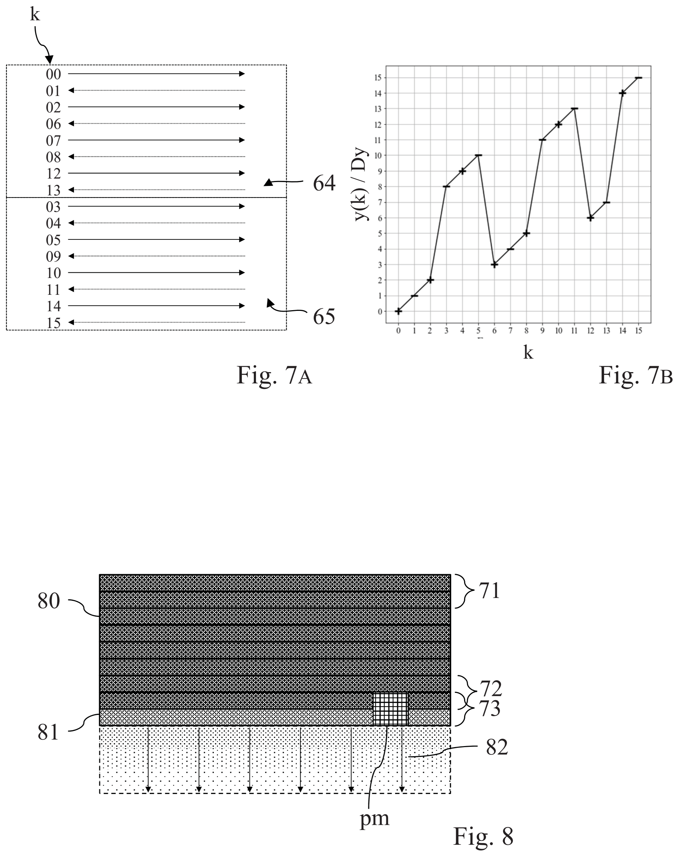

Favorably, the invention employs a bi-direction stripe exposure as proposed by the applicant in US 9,799,487, which further introduced another stripe exposure variant ("clustered regional stripe order") shown in Fig. 7A and Fig. 7B. Similar to the variant of Fig. 6A and 6B, in this variant, the substrate is conceptually split into sub-regions, where the (e.g. eight) stripes of each region exposed in top-down order with alternating exposure direction and switching between sub-regions after a pre-defined number of stripes within each group have been exposed (e.g. 3 stripes in the example shown in Fig. 7A). In Fig. 7B and like depictions of y(k)/Dy as function of k herein, the symbols + and - additionally indicate the writing direction along the uniform general direction d1, i.e., along the "positive" scanning direction sd and "negative" scanning direction sd', respectively.

## Charging effect

A critical issue with regard to pattern placement fidelity ("global registration") is the build-up of charge generated by back-scattered particles in the resist 17, which can deflect the charged-particle beam and degrade placement accuracy. Patterns of sufficient size typically lead to a significant charge-up of the substrate in the millimeter range. The effect is described in detail in [reference]. The effect is illustrated in Fig. 8 for the "top-down" stripe ordering of Fig 5A. The previously exposed half-stripes 80 (with a width corresponding to the offset Dy being half the effective stripe width ys) received their nominal charged-particle dose, whereas the most recent half-stripe 81 so far has been written by the pattern image pm at only half of the intended dose. Backscattered and secondary particles generated during exposure of the stripes 80, 81 generate a "charge front" 82 (which, for simplicity is only shown in downward direction, also note that the real charge distribution may be more sophisticated) with a charge gradient generating an electric field which deflects forthcoming stripes downward. This will cause a misplacement of the stripes which will increase with the number of adjacent stripes exposed. Hence, it is desirable to distribute the charge as evenly as possible to homogenize the electric field on the mask.

## Stripe caching

Another important consideration with regard to stripe ordering is that a stripe ordering should be compatible with a stripe caching window. During a typical "multi-pass" exposure, the vector pattern has to be processed (e.g. corrected for proximity or other charged-particle beam or processing effecting) and converted into pixel data before the stripe can be exposed. Furthermore, when utilizing overlapping exposure stripes, the modified vector data and generated pixel data have to be re-used, e.g. for the exposing the other passes after writing the first pass. Hence, in order to reduce processing time, the modified vector pattern and/or pixel data may be cached in a stripe cache of a given number (e.g. 30 to 40) of exposure stripes. In a typical implementation, substripes (e.g. an integer fraction $1/n_p$ of a full stripe) are added to the cache when required and deleted from the cache following a LRU ("Least Recently Used") strategy.

A possible alleviation (in the context of a "double-pass" exposure) of the charging effect is obtained by writing all stripes of the second pass only after all stripes of the first pass have been exposed. With that approach, a charging front with only half the amount of charge (and therefore also half the beam deflection due to resist charging) is generated. Another solution is the use of a "regional stripe ordering" or "clustered regional stripe ordering" (Figs. 6A+6B or Figs. 7A +7B) with a sufficient amount of sub-regions, which allow for a comparatively homogeneous build-up of charge. When utilizing a large number of regions, however, both of these approaches are not generally compatible with stripe caching, since a large amount of other stripes may be written between the exposure of the first and second pass of a half-stripe, which will exceed the capacity of the cache so the stripe data cannot be kept in the cache and need to be re-processed.

## Beam drift

During the exposure process within a typical charged-particle exposure apparatus, it is generally observed that the beam position deviation from its nominal position may continuously change, for instance due to charge accumulation on components of the projection optics system 5 of the exposure apparatus (as e.g. described in US 10,325,756 B2 by the applicant) or heating of the substrate (see US 2023/0296989 A1). These effects can largely be mitigated by suitable compensation methods; typically, however, a significant residual error remains.

It is generally undesirable to write neighboring or overlapping stripes with a large deviation of beam position (more than a nanometer), since this may introduce additional blur and/or lead to stripe butting errors, in particular at the interface of two regions 64, 65 when utilizing a "regional stripe ordering" stripe placement strategy. Hence, since the change of beam position is gradual, it is advantageous to limit the time delay between the exposure of neighboring and/or overlapping stripes; or, alternatively, to keep low the number of (temporally intermediate) stripes that are written between neighboring or overlapping stripes are written.

**Stripe window**

The invention proposes a novel particle-beam writing method which employs a modified sequence of stripe placement, in order to address and mitigate the issues of resist charging (for which a large temporal offset between neighboring exposure stripes and/or even distribution of charge is desirable) while respecting the restriction that all neighboring stripes are exposed with a limited amount of temporally intermediate stripes. As a desired feature of the stripe placement method, the number of intermediate stripes exposed between the exposure of neighboring stripes is bounded by the number of stripes in the stripe cache; the resulting stripe exposure order will consequently also be cacheable, since a specific piece of stripe data can be removed from the cache once all stripes that the piece of stripe data describes (e.g. all the overlapping stripes that include the stripe data) has been exposed. This goal is achieved by choosing an exposure sequence which re-orders the time sequence of stripes, but which also satisfies the requirement that, for each stripe position $y_k = k \cdot Dy$ in the exposure sequence, a stripe which is contained among a local window of allowable stripes close to the k-th stripe position $y_k$ is exposed. This local window is also referred to as "stripe window". Favorably, a "stripe wing number" w is defined so the stripe window contains w stripes spatially preceding and following the k-th stripe at stripe position $y_k = k \cdot Dy$. In other words, the stripe window will contain 2w+1 stripes. By virtue of this requirement, at most 2w stripes are exposed between the exposure of spatially neighboring stripes. Favorably, the stripe wing number is chosen to be equal or smaller than the size of the stripe cache, with the stripes therefore being written in accordance with a stripe window that does not exceed the size of the cache.

**Cyclical shuffled stripe ordering**

A first embodiment of the invention is favorably implemented and described in combination with a multi-pass write strategy employing $n_{passes}$ distinct passes; in general, though, it is also applicable with a single-pass write strategy. Herein, the term "passes" corresponds to mutually disjoint sets of neighboring (non-overlapping or only marginally overlapping) stripes; $n_{passes}$ is the number of passes, and preferably each pass contains the same number of stripes (possibly with a difference of one stripe where the total number N of stripes is not an integer multiple of the number of passes). The stripes are numbered by their stripe position $y_k$ with respect to the Y-direction, generating a cyclical numbering through the passes so each $n_{passes}$-th stripe belongs to the same pass. The basic idea behind this embodiment is that the passes are cycled through iteratively, but start with a (temporal) offset relative to each other. Each pass generates a fractional charge front 82, but due to the temporal offsets for each pass, the superimposed total charge front is smeared out.

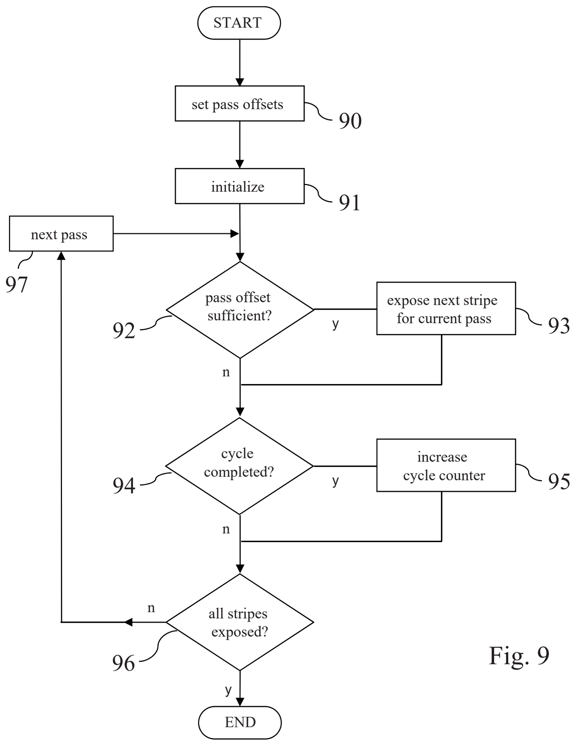

The algorithm for the first embodiment of the invention is illustrated with a flowchart in Fig. 9. In a first step 90, offsets (given in number of cycles, where a cycle is a set of $n_{passes}$ consecutive stripes, preferably starting with the stripe of the first pass, i.e. pass index p=0) for each of the passes are chosen. The offsets can be chosen arbitrarily in general, but advantageously, the offsets are chosen such that the difference of consecutive offsets (in number of cycles) between the one pass and the next one is approximately equal (since this will result in a homogeneous spacing of charge fronts), e.g. by choosing the offset for the p-th pass $\omega_p$ to be

$$\omega_p = \left\lfloor \frac{p}{n_{passes}} \cdot \frac{n_w - 1}{n_{passes} - 1} \right\rfloor, \qquad p = 0, \dots, n_{passes} - 1,$$

with the brackets $\lfloor \rfloor$ denoting the rounding-down operation (so-called "floor" function), $n_{passes}$ is the number of passes, and $n_w$ is a parameter which can be chosen freely as a number not exceeding the size of the stripe window, i.e. $n_w <= 2w+1$, while the stripe window 2w+1 is suitably chosen to be smaller than the maximum number of full stripes that can be held in the cache, multiplied with $n_{passes}$. In particular, the offset for the last pass may favorably be equal to the stripe window size (in terms of full cycles); this can ensure that a stripe is removed from the stripe cache only after the last pass overlapping it is exposed.

In the second step 91, the current pass index p and the number of completed cycles $n_{cycles}$ are initialized to 0 (for simplicity, we use pass indexing starting at 0).

Next, in step 92, it is checked whether a sufficient amount of cycles has passed for the current pass p, i.e. if $n_{cycles} \geq \omega_p$. If that is not the case (or if all stripes of the current pass have already been exposed), the stripe exposure is skipped.

If that is the case, the next stripe in the current pass p is exposed in step 93, ideally this is the top-most stripe corresponding to the current pass (such that the individual passes are exposed top-down). In general, however, other stripe orderings of the individual passes can be chosen. Passes with an uneven index (for instance the first and third pass in a "quad-pass" exposure) are favorably written in the same direction (e.g. positive x-direction), whereas passes with an even index are written in the opposite direction (e.g. negative y-direction).

Next, in the steps 94, 95 the cycle counter $n_{cycles}$ is incremented if a cycle has been completed, i.e. if $p = n_{passes}$. Finally, in step 96, it is check whether all stripes have been exposed, leading to the end or the exposure process. If not, in step 97 the current pass is cyclically updated with $p \leftarrow mod(p + 1, n_{passes})$ to close the loop.

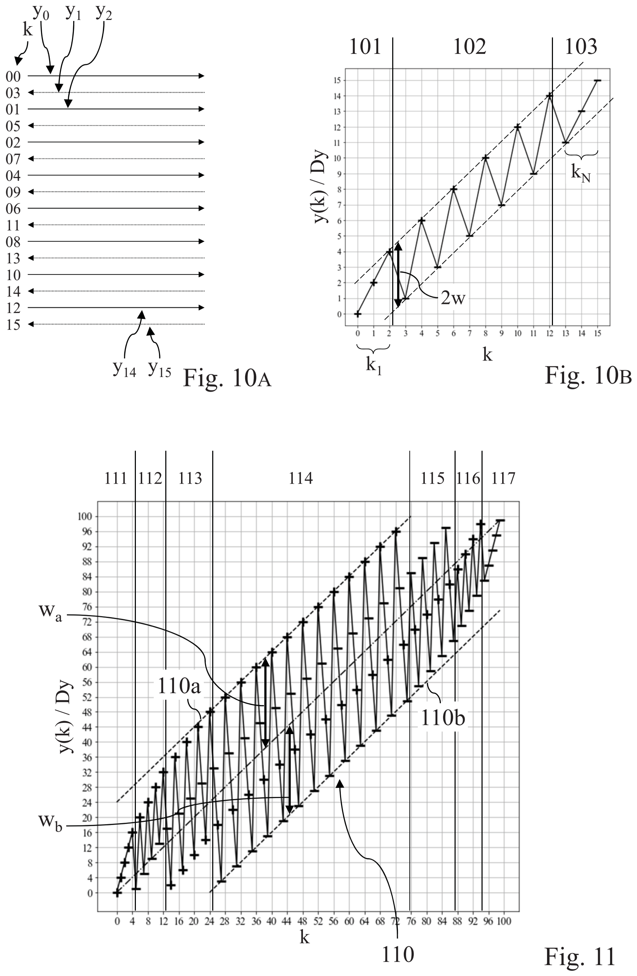

The stripe window corresponding to the first embodiment of the invention contains 2w+1 stripe positions, which will in general include stripes from all passes. An example of the procedure according to the first embodiment is shown in Figs. 10A and 10B, which illustrate the stripe ordering of 16 stripes (again overlapping in "double-pass" placement) according to the invention with a stripe caching window capable to hold the data of 3 full stripes and stripe wing number w = 2 (which corresponds to contiguous 5 stripe positions). (It will be appreciated that the numbers given in the example are merely for illustration purposes, whereas in a realistic application, in order to actually reduce the charging effect, a larger window would be necessary.) The pass offsets for this example are $\omega_0 = 0$, $\omega_1 = 2$. First, in an initial phase 101 only the $k_1 = \omega_1 - \omega_0 + 1 = 3$ stripes of the first pass (i.e. every second stripe) are exposed until two cycles have passed (and the cached number of full stripes is spanned by the first pass). Then, in the main phase 102, in an alternating manner, stripes of the second and first pass are exposed, both in top-down order until the last stripe of the first pass is exposed. Finally, in a final phase 103, the remaining $k_N = k_1 = 3$ stripes of the second pass are filled up.

phase 101:     $y(k) = Dy \cdot 2k$                                          $k = 0 ... k_1 - 1$

phase 102:     $y(k) = Dy \cdot ( (2w+1+k-k_1) - 2w \cdot (k \; mod \; 1) )$

               $= Dy \cdot ( (k+2) - 4(k \; mod \; 1))$                       $k = k_1 ... N - k_N - 1 = 3...12$

phase 103:     $y(k) = Dy \cdot (2k - 15)$                                   $k = N - k_N ... N - 1 = 13...15$

These values of y(k) can also be read off directly from the graph (symbols + and -) in Fig. 10.

Another example of the invention according to the first embodiment is shown in Fig. 11 for 100 stripes placed with a "quad-pass" strategy ($n_{passes} = 4$) and a stripe wing number w = 24, corresponding to a caching window of 13 full stripes (49 stripe positions). Following the recipe above referring to Figs. 9 and 10, the pass offsets are given by $\omega_0 = 0$, $\omega_1 = 4$, $\omega_2 = 8$, $\omega_3 = 12$, corresponding to a stripe wing number w = ($\omega_3 - \omega_0 + n_{passes}$)·($n_{passes} - 1$)/2 = 24. In this example, three initial phases 111, 112, 113 comprising 4 cycles each are completed. These cycles contain less than $n_{passes}$ stripes, and each of the initial phases increases the number of stripes that are exposed in each cycle (in top-down order) by one compared to the phase before. Note that this leads to each phase including more exposure stripes and therefore also requiring more time. In the main phase 114, all passes are cycled through, again in top-down order. Lastly, in the closing phases 115, 116, 117 the remaining stripes are completed, again with consecutively reducing the number of stripes that are exposed in each cycle. In Fig. 11, the stripe window is illustrated as a frame range 110 bounded by the two dashed lines 110a, 110b, which represent the upper and lower boundary of the stripe window, respectively. Each of the lines 110a, 100b is at a distance $w_a$, $w_b$ to the center diagonal (shown as dash-dotted line) equal to the stripe wing number w = 24 when taken along the y-direction. As can be seen in Fig. 11, the position of each stripe is within the stripe window 110 (including the boundaries represented by the lines 110, 110b). The values of y(k) are directly derivable from the graph (i.e. the symbols + and -) given in Fig. 11.

This approach of cyclical shuffled stripe ordering may also generalized from passes to groups of stripes, referred to as sequence groups, where each of the $n_p$ sequence groups only contain every $n_p$-th stripe of the set of stripes according to the width index i. Then the above procedure can be applied *mutatis mutandis,* using respective pass offsets for each of the sequence groups.

**Group-shuffled stripe ordering**

In another embodiment of the invention, exposure stripes are conceptually bundled into groups which are rearranged, preferably being cycled through in a similar manner as the passes in the embodiment of the previous section. This embodiment is independent of the multi-pass write-strategy chosen, rather, stripes are numbered top-down by means of the width index i; moreover, they may have arbitrary overlaps.

In a first step, a conceptual permutation of stripes, according to their indices i, is performed as follows: A number of same-size blocks containing $n_{block}$ of the indices i of the exposure stripes in the exposure area are selected. If the number of stripes is not a multiple of $n_{block}$, fictitious stripe indices may be added as dummy stripes (which are skipped in the final writing process). Favorably, the number of stripes in the blocks is less than the maximum number ($n_{cached}$) of full stripes that can be held in the caching window (the cached stripes, possibly overlapping, at a given time of exposure), typically an integer fraction, i.e. $n_{block} < n_{cached}/m$, with m being a number greater than 1, in particular an integer number $\geq 2$. The elements within the blocks are then permuted with a permutation $\sigma_{block}$ of the numbers 0, ..., $n_{block} - 1$. In a favorable variant of the invention, the permutation $\sigma_{block}$ is generated via Fibonacci-hashing, that is, using a suitable positive number smaller 1, preferably the golden ratio $\phi^{-1} = \frac{\sqrt{5}-1}{2}$ = 0,610803..., and the floor operator $\lfloor \cdot \rfloor$. Thus, $\sigma_{block}(i)$ is given as the i-th element of the series

$$(\lfloor n_{block} \cdot k\phi^{-1} \rfloor \bmod n_{block})_{k \in \mathbb{N}}$$

with duplicate entries removed, which is applied to the set of (reduced) stripe indices i = 0, ..., $n_{block}$ - 1 within each group; the groups are generated by even splitting of the total set of stripe indices. Also, in place of $\phi^{-1}$ another suitable rational or irrational number chosen from the unit interval (0,1) might be used, such as 81/127 ≈ 0.6378 (in case of a rational number, the denominator should be chosen suitably large and relative prime to $n_{block}$), $1/\sqrt{2} \approx 0,7071$ or e/2π = 0.4326. More generally, however, other permutations (such as random permutations) of the block can also feasibly utilized for the invention. Mathematically, using a permutation $\sigma_{block}$ of elements of the first block, a permutation (or stripe order) $\sigma$ of all stripes in the exposure area is generated by periodic continuation

$$\sigma(i) = \sigma_{block}(i \bmod n_{block}) + \lfloor i/n_{block} \rfloor n_{block},$$

that is, by repeating the block stripe order of the premutation $\sigma_{block}(i)$ every $n_{block}$ stripes (with an offset $n_{block}$). An example of the procedure is shown starting from a plurality of stripes as shown in Fig. 12A for $n_{block}$ = 15, $n_{stripes}$ = 90. As shown in Fig. 12B, the stripes numbered by indices i= 0...14 in the block 120 are permuted with Fibonacci-hashing and the same reordering is continued periodically with the other blocks 121 to obtain a permutation of all stripes (indices i=0...89) in the exposure area; the total number of blocks is B = $n_{stripes}$ /$n_{block}$ (or, if this would yield a non-integer number, $\lfloor (n_{stripes} - 1)/n_{block} \rfloor + 1$ ).

The stripe order as shown in Fig. 12B can be directly used, or another step of rearranging the stripe order may be added as illustrated in Fig. 12C.

In such a next step, the permuted stripes are conceptually distributed into a number of groups, $n_{groups}$ groups 126 as illustrated in Fig. 12C. Here, the blocks are split evenly into $n_{groups}$ =3 groups 122. This generates a number of block portions, which are rearranged to form new groups, referred to as "cohort" 123, 124, 125, 126, 127, where the j-th cohort (with j running from 0 to B+$n_{groups}$ -2) comprises up to $n_{groups}$ block portions, namely, the m-th block portion of the (j-m)-th block (provided 0≤j-m<B) for all values of m=0...$n_{groups}$ -1. In other words, with respect to a linear numbering of all M=B·$n_{groups}$ block portions, the j-th cohort comprises a span of every (n-1)-th block portion, comprising the block portions of portion indices m=n·j, n·j-(n-1), ..., n·j-(n-1)², but leaving out values of indices m which do not fall within the range of 0≤m<M.

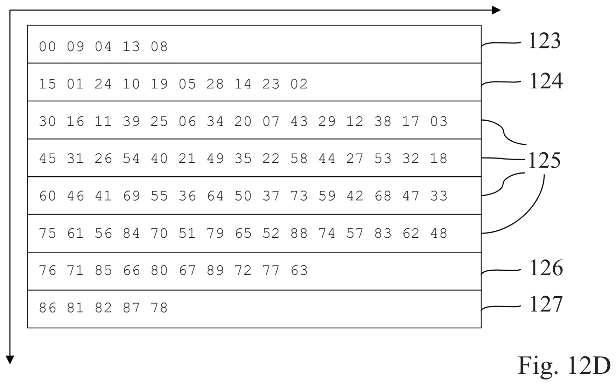

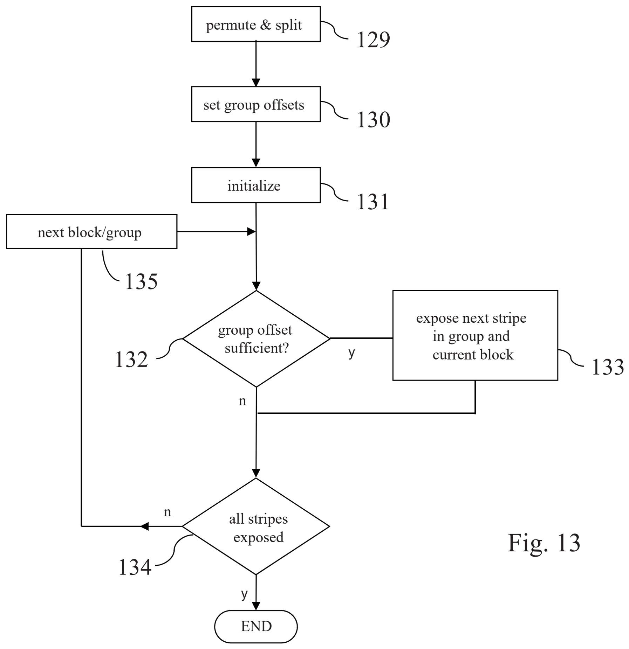

During exposure, the stripes of the blocks 120, 121, or the cohorts 123-127, as illustrated in Fig. 12D, are exposed in ascending order of the respective group index (index of blocks, or index j of cohorts, respectively) and stripe number within each group. The method is also shown in the flowchart of Fig. 13. In Fig. 13, for simplicity of depiction, only one loop is shown for controlling the indices of groups and blocks, which is representative of two nested loops that respectively run over the block index and the group position (index m or j for the block portions or cohorts).

In a first step 129, the exposure stripes are permuted and split into groups as described above. Next, starting offsets for the exposure of the groups are chosen in step 130. Typically, an additional group is added to the exposure cycle after a full block (of each group in the exposure cycle) has been completed, that is, by choosing the offset for the kth group $v_k$ to be

$$v_k = k, \qquad k = 0, ..., n_{groups} - 1.$$

In the second step 1311, the current group k and block j are initialized to 0 (again using indexing starting at 0).

Next, in step 132, it is checked whether a sufficient amount of blocks have been exposed to expose stripes of the current group k, i.e. if j≥ $v_k$. If that is the case, the next stripe in the current pass group k and block j is exposed in step 133. If not, or if all stripes of group k and block j have been exposed, the step is skipped. Again, passes with an uneven index (for instance the first and third pass in a "quad-pass" exposure) are favorably written in the same direction (e.g. positive x-direction), whereas passes with an even index are written in the opposite direction (e.g. negative y-direction).

Next, in the steps 134, 135 the block counter j is incremented if a j has been fully exposed. Finally, the current group k is updated with k ← mod(k + 1, $n_{groups}$) to close the loop; when the last stripe has been exposed, the process terminates.

Note that the first embodiment of the invention corresponds to the case $n_{block} = n_{passes}$, $\sigma_{block} = e$ (trivial permutation which does not reorder) and $n_{groups} = n_{passes}$ with groups assigned according to pass, and a specific choice of group offsets.

Using a group-shuffled stripe ordering has the advantage of increased time delay during the exposure of neighboring stripes, furthermore, the strategy is also applicable for non-overlapping stripes. If the blocks are chosen small enough, the group-shuffled exposure strategy is compatible with a stripe-caching window.

Further examples of the second embodiment of the invention are given in Figs. 14 and 15. The example shown in Fig. 14 (for a minimal stripe wing number of w=18) shows a group-shuffled stripe ordering of 72 stripes for $n_{block}$ = 24 and $n_{groups}$ = 1, clearly showing the even stripe distribution (within each partial sequence corresponding to a block) due to permuting via Fibonacci-hashing. The example shown in Fig. 15, using $n_{block}$ = 15 and $n_{groups}$ = 3, which is compatible with a stripe wing number of w=26, illustrates the combination of group-cycling and permutation within the blocks.

**General window-shuffled stripe orderings**

In a third embodiment, which may be seen as a further generalization, arbitrary permutations of the exposure stripes 62 may be employed which still satisfy the stripe window requirement.

For this purpose, suitable permutations $\sigma$ of the exposure stripes are considered that satisfy

$$|d(\sigma)|(k) = |\sigma(k) - k| \leq w \text{ for } 0 \leq k \leq N.$$

Here, w again denotes the stripe wing number of the invention, with the corresponding window size W=2w+1, where w is preferably chosen so W=2w+1 is not exceeding ideally matching the maximum number of cachable stripes, possibly overlapping, at any given time of exposure. Further, k denotes the time index and $\sigma(k)$ the spatial index of the kth stripe written (top-down), i.e. $y(k) = Dy \cdot \sigma(k)$. the quantity $d(\sigma)$ satisfying $d(\sigma)(k) = \sigma(k) - k$ is called the displacement of the permutation; it is required to be bounded by the wing size.

According to the third embodiment of the invention, to generate a permutation (periodic in the caching window) which satisfies this requirement, first an arbitrary base permutation $\sigma_w$ (e.g. random, via Fibonacci-hashing or optimized in some other way) of a window containing $2w + 1$ stripes is selected.

In a next step, a modified window permutation $\overline{\sigma_w}$ (mapping from the window $\{0, \dots, W - 1\}$ to $\mathbb{Z}$ ) is generated via

$$\overline{\sigma_w}(i) = \begin{cases} \sigma_w(i) - W & \text{if } d(\sigma_w)(i) > w \\ \sigma_w(i) + W & \text{if } d(\sigma_w)(i) < -w \quad \text{for } 0 \leq i \leq W - 1. \\ \sigma_w(i) & \text{otherwise} \end{cases}$$

That is, the $i$th stripe written is exchanged with one in the previous or next window (with the same value modulo $W$) if it is outside the stripe window.

In the final step, to obtain a permutation of all stripes in the exposure area, the modified permutation is periodically repeated (similar to the approach of the second embodiment) by concatenating $\overline{\sigma_w}$ + zW for $z = -1, \dots, \lceil N/W \rceil + 1$

and removing values which don't correspond to stripes to be written. Here, $\lceil . \rceil$ denotes the ceiling function (rounding up). In other words, by taking copies of $\overline{\sigma_w}$, shifted by multiples of $W$ until all stripes of the exposure of are covered (that is always possible, since the window permutation $\overline{\sigma_w}$ maps to all values 0, ..., $W$ - 1 mod $W$). Note that any permutation with displacement bounded by the stripe wing number w that repeats with period $W$=2w+1 can be generated in this manner.

An example of the third embodiment of the invention is shown in Fig. 16, which utilizes a random permutation, for a stripe window of W=49 stripes (corresponding to a stripe wing number of w=24). Fig. 17 illustrates a further example using a base permutation generated with Fibonacci-hashing for 100 stripes to be exposed with a stripe window containing W=49 stripes.

**Claims**

1. A method for irradiating a target with a beam of energetic radiation formed by electrically charged particles to write a desired pattern, comprising the steps of

   - generating said beam and forming it into a pattern image (pm) on the location of the target (16) using a beam-generating column (10) in accordance with the desired pattern, and
   - generating a relative movement between said target (16) and the beam-generating column (10) producing a movement of said pattern image on the target along an exposure path over an exposure region (R1) where a beam exposure is to be performed, said exposure path being composed of sections which each extend along a general direction (d1), said exposure region being composed of a plurality of pattern pixels or pattern elements (px) arranged in a regular arrangement and said exposure region having a total width (Ry) as measured along a width direction (y) across said general direction (d1), wherein the movement along said exposure path defines a plurality of stripes (s1-sn; 401, 404, 406, 407) extending along the general direction (d1) so as to combine into a cover of the exposure region (R1) in sequential exposures, said plurality of stripes comprising N stripes in said exposure region,

wherein each of the N stripes is located, with respect to the width direction, at a specific stripe location ($y_i$) within said region (R1), the stripes having a predetermined stripe width ys as measured along said width direction (y), wherein said stripe locations form a set of locations $y_i$ in which the stripes are identified by a width index i and the locations $y_i$ are monotonously increasing as a function of the width index i,

wherein the plurality of stripes are written in a time sequence according to a time index k of the stripes, said time index starting from 0 for the stripe that is written first and incrementing by one for each consecutive stripe until N-1, said time sequence obeying the following conditions, which are based on a pre-determined integer number w ("stripe wing number") which is smaller than the number of stripes N divided by at least 4 (i.e., w < N/4):

at each time index k the stripe corresponding to a stripe location y(k) is written, which stripe location y(k) is at most w stripe locations before the stripe location $y_k$ and at most w stripe locations behind the stripe location $y_k$, the stripe location y(k) is different from the k-th stripe location $y_k$ for at least a quarter of the stripes, between each pair of spatially directly neighboring stripes, at most 2w different stripes are written.

2. The method of claim 1, wherein stripe data that relate to a pattern to be written by writing the stripes are cached in a cache memory, and wherein the stripe wing number w is smaller than half the maximum number of stripes whose stripe data said cache memory is capable to keep simultaneously.

3. The method of claim 1 or 2, wherein the stripe wing number w is not larger, or is smaller, than a number calculated by decreasing the number of stripes N by the numbers ($k_1$, $k_N$) of directly adjacent or overlapping stripes that are written at the beginning and at the end of the exposure path, then dividing by 4 (i.e., $w \leq (N-(k_1+k_m))/4$).

4. The method of any one of the preceding claims,

wherein the exposure path comprises several passes, each pass being composed of sections which each extend along a general direction (d1) associated with the respective pass, wherein each pass includes a plurality of stripes (s1-sn; 401, 404, 406, 407) extending along the general direction (d1) of the respective pass and the stripes of each pass combine into a cover of the exposure region (R1) in sequential exposures, and wherein each pass is associated with one of a number of partial grids (G1, G2) of pattern pixels which are exposable during the respective pass, the partial grids (G1, G2) being mutually different and, when taken together, combining to the complete plurality of pattern pixels (px) which are comprised in the exposure region (R1).

5. The method of any one of the preceding claims, wherein between each pair of spatially directly neighboring or overlapping stripes, at least one different stripe is written, preferably at least two different stripes are written, with the exception of directly adjacent or overlapping stripes that are written at the beginning and at the end of the exposure path.

6. The method of any one of the preceding claims, wherein the exposure path comprises several passes as described in claim 4, and between each pair of neighboring stripes of the same pass at least one different stripe is written, preferably at least one stripe from each of the other passes are written.

7. The method of any one of the preceding claims, wherein between each pair of spatially directly neighboring or overlapping stripes, the at most 2w different stripes are written within a maximum distance to said pair of spatially directly neighboring stripes, said maximum distance being at most 2w times the stripe width ys.

8. The method of any one of the preceding claims, wherein the stripe locations of directly subsequent stripes ($y_i$, $y_{i+1}$) differ by a uniform offset Dy, the stripe width ys being an integer multiple of said uniform offset Dy, and the stripe locations $y_i$ form a linear sequence according to $y_i = y_0 + i.Dy$, wherein preferably the exposure path comprises several passes as described in claim 4 and the uniform offset Dy is the stripe width ys divided by the number of passes.

9. The method of any one of the preceding claims, wherein the time sequence corresponds to a permutation of stripes within conceptual blocks (120, 121) of stripes, each of said blocks comprising the same number ($n_{block}$) of stripes except for rounding corrections, said number ($n_{block}$) of stripes within the blocks being chosen not exceeding 2w+1.

10. The method of any one of the preceding claims, wherein the time sequence corresponds to a permutation of block portions of stripes according to a conceptual partitioning of the sequence of stripes into consecutive block portions, conceptually numbered by a portion index m running from 0 up to M-1, and rearranging the order of block portions by grouping together up to n block portions into n-1+M/n mutually disjoint groups referred to as cohorts (123-127), said cohorts being conceptually numbered by a cohort index j starting from 0, where the j-th cohort comprises a span of every (n-1)-th block portions, comprising the portion indices m=n·j, n·j-(n-1), ..., n·j-(n-1)$^2$ falling within the range of 0≤m<M; where the maximum number of stripes within each of said cohorts being chosen not exceeding 2w+1.

11. The method of any one of the preceding claims, wherein the time sequence corresponds to conceptual partitioning of stripes into at least two mutually disjoint sequence groups, each sequence group comprising a set of stripes which corresponds to every $n_p$-th stripe in the set of stripes as numbered by the width index i, where $n_p$ is the number of sequence groups, wherein based on $n_p$-1 pre-defined offsets $\omega_p$, where $\omega_0$=0 and $\omega_p + 1 < \omega_{p+1}$ for p=0... $n_p$-2, each non-first sequence group starts with its respective first stripe only after the first $\omega_{p+1} - \omega_p$ stripes of the respectively preceding sequence groups have been written, writing the stripes by cycling through the sequence groups which have been started and are not yet completed; the offsets being chosen such that 2w > ($\omega_{np} -\omega_0 + n_p$)·($n_p - 1$).

12. The method of claim 11, wherein the sequence groups are passes as described in claim 4, and/or the stripes of each sequence groups are mutually non-overlapping or only marginally overlapping.

13. The method of any one of the preceding claims, wherein the pattern image (pm) includes a plurality of aperture images covering a plurality of pixels on the target, and/or wherein generating said beam and forming it into a pattern image (pm) includes:

   - providing a pattern definition device (4) having a plurality of apertures (24) transparent to said radiation,
   - illuminating said pattern definition device by means of an illuminating wide beam (lb), which traverses the pattern definition device through said apertures thus forming a patterned beam (pb) consisting of a corresponding plurality of beamlets,
   - forming said patterned beam into a pattern image (pm) on the location of the target (16), said pattern image comprising the images of at least part of the plurality of apertures.

Fig. 1 (prior art)

Fig. 2
(prior art)

Fig. 3
(prior art)

Fig. 4

Fig. 5A

Fig. 5B

Fig. 6A

Fig. 6B

Fig. 7A

Fig. 7B

Fig. 8

Fig. 9

Fig. 10A

Fig. 10B

Fig. 11

| 00 | 01 | 02 | 03 | 04 | 05 | 06 | 07 | 08 | 09 | 10 | 11 | 12 | 13 | 14 |
| 15 | 16 | 17 | 18 | 19 | 20 | 21 | 22 | 23 | 24 | 25 | 26 | 27 | 28 | 29 |
| 30 | 31 | 32 | 33 | 34 | 35 | 36 | 37 | 38 | 39 | 40 | 41 | 42 | 43 | 44 |
| 45 | 46 | 47 | 48 | 49 | 50 | 51 | 52 | 53 | 54 | 55 | 56 | 57 | 58 | 59 |
| 60 | 61 | 62 | 63 | 64 | 65 | 66 | 67 | 68 | 69 | 70 | 71 | 72 | 73 | 74 |
| 75 | 76 | 77 | 78 | 79 | 80 | 81 | 82 | 83 | 84 | 85 | 86 | 87 | 88 | 89 |

Fig. 12A

| 00 | 09 | 04 | 13 | 08 | 01 | 10 | 05 | 14 | 02 | 11 | 06 | 07 | 12 | 03 |
| 15 | 24 | 19 | 28 | 23 | 16 | 25 | 20 | 29 | 17 | 26 | 21 | 22 | 27 | 18 |
| 30 | 39 | 34 | 43 | 38 | 31 | 40 | 35 | 44 | 32 | 41 | 36 | 37 | 42 | 33 |
| 45 | 54 | 49 | 58 | 53 | 46 | 55 | 50 | 59 | 47 | 56 | 51 | 52 | 57 | 48 |
| 60 | 69 | 64 | 73 | 68 | 61 | 70 | 65 | 74 | 62 | 71 | 66 | 67 | 72 | 63 |
| 75 | 84 | 79 | 88 | 83 | 76 | 85 | 80 | 89 | 77 | 86 | 81 | 82 | 87 | 78 |

— 120

— 121

Fig. 12B

123   124   125

| 00 | 09 | 04 | 13 | 08 | 01 | 10 | 05 | 14 | 02 | 11 | 06 | 07 | 12 | 03 |
| 15 | 24 | 19 | 28 | 23 | 16 | 25 | 20 | 29 | 17 | 26 | 21 | 22 | 27 | 18 |
| 30 | 39 | 34 | 43 | 38 | 31 | 40 | 35 | 44 | 32 | 41 | 36 | 37 | 42 | 33 |
| 45 | 54 | 49 | 58 | 53 | 46 | 55 | 50 | 59 | 47 | 56 | 51 | 52 | 57 | 48 |
| 60 | 69 | 64 | 73 | 68 | 61 | 70 | 65 | 74 | 62 | 71 | 66 | 67 | 72 | 63 |
| 75 | 84 | 79 | 88 | 83 | 76 | 85 | 80 | 89 | 77 | 86 | 81 | 82 | 87 | 78 |

— 126

— 127

122

Fig. 12C

```
00 09 04 13 08                                                    ─── 123

15 01 24 10 19 05 28 14 23 02                                    ─── 124

30 16 11 39 25 06 34 20 07 43 29 12 38 17 03

45 31 26 54 40 21 49 35 22 58 44 27 53 32 18     ─── 125

60 46 41 69 55 36 64 50 37 73 59 42 68 47 33

75 61 56 84 70 51 79 65 52 88 74 57 83 62 48

76 71 85 66 80 67 89 72 77 63                                    ─── 126

86 81 82 87 78                                                   ─── 127
```

Fig. 12D

permute & split — 129

set group offsets — 130

initialize — 131

next block/group — 135

group offset sufficient? — 132

expose next stripe in group and current block — 133

y

n

all stripes exposed — 134

n

y

END

Fig. 13

Fig. 14

Fig. 15

Fig. 16

Fig. 17

# EUROPEAN SEARCH REPORT

Application Number

EP 25 22 6712

Europäisches
Patentamt
European
Patent Office
Office européen
des brevets

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | US 2015/028230 A1 (PLATZGUMMER ELMAR [AT]) 29 January 2015 (2015-01-29) * abstract * * paragraphs [0002], [0020], [0037] - [0038], [0067] - [0079], [0117] - [0138]; claims 1-3,10-12; figures 1,2,14A-18 * | 1-13 | INV. H01J37/302 H01J37/317 |
| A,D | US 2016/276131 A1 (PLATZGUMMER ELMAR [AT]) 22 September 2016 (2016-09-22) * abstract * * paragraphs [0002], [0017], [0030], [0067] - [0088], [0133]; claims 1,11; figures 1-3,24A,24B * | 1-13 | |
| A,D | US 2016/336147 A1 (PLATZGUMMER ELMAR [AT]) 17 November 2016 (2016-11-17) * abstract * * paragraphs [0002], [0030], [0054] - [0070]; figures 1-3 * | 1 | |
| A | US 5 194 741 A (SAKAMOTO KIICHI [US] ET AL) 16 March 1993 (1993-03-16) * abstract * * column 7, line 62 - column 15, line 48; figures 1,5-23 * | 1 | TECHNICAL FIELDS SEARCHED (IPC)<br><br>H01J |
| A | US 2014/017349 A1 (YASHIMA JUN [JP] ET AL) 16 January 2014 (2014-01-16) * abstract * * paragraphs [0038] - [0061]; figures 1-5 * | 1 | |
| A | US 6 064 807 A (ARAI SOICHIRO [JP] ET AL) 16 May 2000 (2000-05-16) * abstract * * column 5, line 2 - column 8, line 67; figures 4-11 * | 1 | |

The present search report has been drawn up for all claims

| Place of search | Date of completion of the search | Examiner |
|---|---|---|
| Munich | 18 May 2026 | Lang, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                                    
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 22 6712

This annex lists the patent family members relating to the patent documents cited in the above-mentioned European search report.
The members are as contained in the European Patent Office EDP file on
The European Patent Office is in no way liable for these particulars which are merely given for the purpose of information.

18-05-2026

| Patent document cited in search report | Publication date | Patent family member(s) | Publication date |
|---|---|---|---|
| US 2015028230 A1 | 29-01-2015 | EP 2830083 A1 | 28-01-2015 |
| | | JP 6264613 B2 | 24-01-2018 |
| | | JP 2015029096 A | 12-02-2015 |
| | | US 2015028230 A1 | 29-01-2015 |
| US 2016276131 A1 | 22-09-2016 | EP 3096342 A1 | 23-11-2016 |
| | | JP 6723776 B2 | 15-07-2020 |
| | | JP 2016178300 A | 06-10-2016 |
| | | KR 20160113005 A | 28-09-2016 |
| | | US 2016276131 A1 | 22-09-2016 |
| US 2016336147 A1 | 17-11-2016 | NONE | |
| US 5194741 A | 16-03-1993 | NONE | |
| US 2014017349 A1 | 16-01-2014 | DE 102013213307 A1 | 16-01-2014 |
| | | JP 6027798 B2 | 16-11-2016 |
| | | JP 2014017391 A | 30-01-2014 |
| | | KR 20140007757 A | 20-01-2014 |
| | | TW 201413369 A | 01-04-2014 |
| | | US 2014017349 A1 | 16-01-2014 |
| US 6064807 A | 16-05-2000 | JP H07191199 A | 28-07-1995 |
| | | US 6064807 A | 16-05-2000 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9520268 B
- US 6768125 B
- US 8222621 B
- US 8378320 B
- US 9053906 B
- US 9799487 B
- US 10410831 B
- US 10325757 B
- US 6858118 B
- US 8198601 B2
- US 10325756 B2
- US 20230296989 A1